# EUROPEAN PATENT SPECIFICATION

(11) **EP 2 757 136 B1**
(45) Date of publication and mention of the grant of the patent: **01.11.2017**
(21) Application number: 12846444.3
(22) Date of filing: 20.09.2012
(51) Int. Cl.: C09J 153/02, C09J 7/02, C09J 109/06, H01L 21/304, B32B 7/06

(54) **METHOD USING AN ADHESIVE COMPOSITION FOR BONDING WAFER AND SUPPORTING BODY FOR SAID WAFER**
VERFAHREN MIT EINER HAFTZUSAMMENSETZUNG ZUM WAFER-BONDEN UND TRAGKÖRPER FÜR DIESEN WAFER
PROCEDE UTILISANT UNE COMPOSITION ADHÉSIVE POUR LIER UNE TRANCHE ET UN CORPS DE SUPPORT POUR LADITE TRANCHE

(30) Priority: 31.10.2011 JP 2011239476
(43) Date of publication of application: 23.07.2014
(73) Proprietor: Tokyo Ohka Kogyo Co., Ltd., Kawasaki-shi, Kanagawa 211-0012 (JP)
(72) Inventor: IMAI, Hirofumi, Kanagawa 211-0012 (JP); OGATA, Toshiyuki, Kanagawa 211-0012 (JP); KUBO, Atsushi, Kanagawa 211-0012 (JP); YOSHIOKA, Takahiro, Kanagawa 211-0012 (JP)
(74) Representative: Cabinet Plasseraud
(86) International application number: PCT/JP2012/074014
(87) International publication number: WO 2013/065417

(56) References cited:
- JP-A- 2005 183 689
- JP-A- 2010 050 321
- JP-A- 2011 122 069
- JP-B2- 3 326 195
- US-A- 5 851 664

## Description

### Technical Field

The present invention relates to an adhesive composition for bonding a wafer and a support for the wafer, adhesive film, and a laminate.

### Background Art

Products such as a mobile telephone, digital AV equipment, and an IC card have been improved to have more sophisticated functions. This gives rise to an increase in a demand that semiconductor silicon chips (hereinafter, referred to as chips) provided in the products are downsized and thinned so that silicon can be provided with higher density in a package. For example, for an integrated circuit in which a plurality of chips are provided in one package, such as a CSP (chip size package) or an MCP (multi-chip package), there is a demand that the chips be thinned. In order to provide the chips with higher density in the package, it is necessary to thin the chips to a thickness in a range of 25 **µ**m to 150 **µ**m.

By a grinding process, semiconductor wafers (hereinafter, referred to as wafers) which serve as bases for the respective chips are thinned. This, however, weakens the strength of the wafers. With the strengths of the wafers being weakened, it is easy for cracks or warpages to be formed in the wafer. Further, the wafers weakened in strength through the thinning are difficult to be transferred automatically and need to be transferred manually. As can be understood from this, handling of the wafers is troublesome.

As a countermeasure, a wafer handling system is developed which adds strengths to the wafers. According to the wafer handling system, a plate called a support plate, which is made from glass, or rigid plastic, is attached to the wafers to be thinned so that the wafers are prevented from being cracked or warped. Because the strengths of the wafers can be secured by the wafer handling system, it is possible to automatically transport the wafers after the thinning process.

In the wafer handling system, the wafers and the support plate are attached to each other by use of an adhesive tape, a thermoplastic resin, or an adhesive. Then, the wafers to which the support plate is attached are thinned. After this, the support plate is peeled off from a substrate before the wafers are diced. Specifically, in a case where the wafer and the support plate are attached to each other with the use of the adhesive, the wafers are peeled off from the support plate by dissolving the adhesive.

As the adhesive, hydrocarbon-based adhesives have been developed in recent years (see Patent Literatures, PTL 1 and PTL 2). Another example of the related art can be found in JPH05125338A [PTL 3] and US5851664A [PTL 4]. Japanese patent application Nr. JPH05125338A, discloses an invention relates to a pressure-sensitive adhesive tapes used in the process of manufacturing the various semiconductors. US application relates to adhesive compositions and tapes with thermoplastic elastomer block copolymer which are used in grinding and dicing of semiconductor wafers.

### Citation List

### Patent Literature

[PTL 1] Japanese Translation of PCT international publication, Tokuhyo, No. 2009-529065 A (Publication Date: August 13, 2009)
[PTL 2] Japanese Translation of PCT international publication, Tokuhyo, No. 2010-506406 A (Publication Date: February 25, 2010)
[PTL 3] JPH05125338A, Furukawa Electric Co Ltd, (Publication Date: May 21, 1993)
[PTL 4] US5851664A, Bennett Richard E [US] et al, (Publication Date: December 22, 1998)

### Summary of Invention

### Technical Problem

In the adhesive in the related art, in a case where a wafer and a support thereof are separated after the wafer and the support for the wafer are bonded to each other, and then subjected to predetermined processes including a thinning process, or in a case where, even if the separation is performed by another method, an adhesive which remains after the separation is removed, there was a problem in that it is difficult to dissolve the adhesive in a solvent for dissolving it.

Herein, an object of the invention is to provide an adhesive composition which can be more quickly removed by dissolving in a solvent when or after a wafer and a support are separated after the wafer and the support for the wafer have been bonded to each other.

### Solution to Problem

In order to solve the problems, the adhesive composition for bonding a wafer and a support for the wafer according to the invention contains an elastomer in which a styrene unit is contained as a constituent unit of a main chain, the content of the styrene unit is 14% by weight to 50% by weight, and a weight average molecular weight is 10,000 to 200,000.

The other objects, features and advantages of the invention will be made sufficiently clear from the following description.

### Advantageous Effects of Invention

According to the invention, the effect is exhibited that the adhesive composition can be more quickly removed by dissolving in a solvent when or after a wafer and a support are separated after the wafer and the support for the wafer were bonded to each other.

### Description of Embodiments

The adhesive composition for bonding a wafer and a support for the wafer according to the invention (hereinafter, simply referred to as "the adhesive composition according to the invention") contains an elastomer in which a styrene unit is contained as a constituent unit of a main chain, the content of the styrene unit is in a range of 14% by weight to 50% by weight, and a weight average molecular weight is in a range of 10,000 to 200,000.

### [Elastomer]

The elastomer which is contained in the adhesive composition according to the invention is not particularly limited as long as it contains a styrene unit as a constituent unit of a main chain, the content of the styrene unit be in a range of 14% by weight to 50% by weight, and a weight average molecular weight be in a range of 10,000 to 200,000.

"A constituent unit" in the present specification refers to a structure resulting from a monomer of one molecule in a structure constituting a polymer.

"A styrene unit" in the specification is a constituent unit resulting from the styrene contained in the polymer when styrene or a styrene derivative is polymerized, and the "styrene unit" may have a substituent. Examples of the substituent that the styrene unit may have include an alkyl group having 1 to 5 carbon atoms, an alkoxy group having 1 to 5 carbon atoms, an alkoxyalkyl group having 1 to 5 carbon atoms, an acetoxy group and a carboxyl group.

When the content of the styrene unit is in a range of 14% by weight to 50% by weight, and the weight average molecular weight of an elastomer is in a range of 10,000 to 200,000, the adhesive composition can be removed more easily and quickly since it is easily dissolved in hydrocarbon solvents described below. In addition, if the content of the styrene unit and the weight average molecular weight of the elastomer are in the above-described range, excellent resistance is exhibited with respect to resist solvents (for example, PGMEA, PGME and the like), acid (hydrofluoric acid and the like) and alkali (TMAH and the like) to which the wafer is exposed when subjected to a resist lithography process.

The content of the styrene unit is more preferably 17% by weight to 40% by weight.

The weight average molecular weight is more preferably in a range of 20,000 to 150,000.

As the elastomer, various elastomers of which the content of the styrene unit is in a range of 14% by weight to 50% by weight, and the weight average molecular weight of an elastomer is in a range of 10,000 to 200,000 can be used. Examples of the elastomer include a polystyrene-poly(ethylene/propylene) block copolymer (SEP), a styrene-isoprene-styrene block copolymer (SIS), a styrenebutadiene-styrene block copolymer (SBS), a styrenebutadiene-butylene-styrene block copolymer (SBBS), an ethylene-propylene terpolymer (EPT) and hydrogenated products thereof, a styrene-ethylene-butylene-styrene block copolymer (SEBS), a styrene-ethylene-propylene-styrene block copolymer (styrene-isoprene-styrene block copolymer) (SEPS), a styrene-ethylene-ethylene-propylene-styrene block copolymer (SEEPS), a styrene-ethyleneethylenepropylene-styrene block copolymer (Septon V9461 (manufactured by KURARAY Co., Ltd.), Septon V9475 (manufactured by KURARAY Co., Ltd.)) of which the styrene block is a reaction crosslinking type) and a styrene-ethylenebutylene-styrene block copolymer (having a reactive polystyrene-based hard block, Septon V9827 (manufactured by KURARAY Co., Ltd.)) of which the styrene block is a reaction crosslinking type, and elastomers of which the content of the styrene unit and the weight average molecular weight are in the above range can be used.

In addition, among the elastomers, a hydrogenated product is more preferable. The hydrogenated product has improved stability with respect to heat, and changes in quality such as decomposition and polymerization are unlikely to occur. In addition, it is more preferable also from the viewpoint of solubility in hydrocarbon-based solvents and resistance to resist solvents.

In addition, among the elastomers, an elastomer of which both terminals are block polymers of styrene is more preferable. This is because higher heat resistance is exhibited by blocking styrene having high heat stability at both terminals thereof. In particular, heat resistance and chemical resistance are excellent when the block site of the styrene is a reactive polystyrene-based hard block.

More specifically, a hydrogenated product of a block copolymer of styrene and conjugated diene is more preferable. Stability with respect to heat is improved, and changes in quality such as decomposition and polymerization are unlikely to occur. In addition, higher heat resistance is exhibited by blocking styrene having high heat stability at both terminals thereof. Furthermore, it is more preferable also from the viewpoint of solubility in hydrocarbon-based solvents and resistance to resist solvents.

A commercially-available product which can be used as the elastomer contained in the adhesive composition according to the invention is, for example, "Septon (product name)" manufactured by KURARAY Co., Ltd., "HYBRAR (product name)" manufactured by KURARAY Co., Ltd., "Tuftec (product name)" manufactured by Asahi Kasei Corporation, or "DYNARON (product name)" manufactured by JSR Corporation.

The content of the elastomer contained in the adhesive composition according to the invention is, for example, preferably 10 parts by weight to 80 parts by weight, and more preferably 20 parts by weight to 60 parts by weight if the total amount of the adhesive composition is 100 parts by weight.

In addition, plural kinds of elastomers may be used in combination. In other words, the adhesive composition according to the invention may contain plural kinds of elastomers. The adhesive composition in which at least one of plural kinds of elastomers contains a styrene unit as a constituent unit of a main chain, the content of the styrene unit is in a range of 14% by weight to 50% by weight, and a weight average molecular weight is in a range of 10,000 to 200,000 is in a scope of the invention. In addition, in the adhesive composition according to the invention, in a case where plural kinds of elastomers are contained, as a result of mixing, the content of the styrene unit is adjusted to be in the above range. For example, when Septon 4033 of Septon (product name) manufactured by KURARAY Co., Ltd. of which the content of the styrene unit is 30% by weight and Septon 2063 of Septon (product name) of which the content of the styrene unit is 13% by weight manufactured by KURARAY Co., Ltd. are mixed at a weight ratio of 1:1, the content of styrene with respect to the entire elastomer contained in the adhesive composition becomes 21% by weight to 22% by weight, and thus, becomes equal to or greater than 14% by weight. In addition, for example, when an elastomer of which the styrene unit is 10% by weight and an elastomer of which the styrene unit is 60% by weight are mixed at a weight ratio of 1:1, the content of styrene becomes 35% by weight, and thus it is within the range. The invention may also be such a form. In addition, it is most preferable that all of the plural kinds of elastomers which are contained in the adhesive composition according to the present invention contain the styrene unit in the above-described range, and a weight average molecular weight is in the above range.

### (Solvent)

The solvent which is contained in the adhesive composition according to the invention is not limited as long as it can dissolve the elastomer. For example, the solvent can be a nonpolar hydrocarbon-based solvent, a polar petroleum-based solvent, or an apolar petroleum-based solvent.

Preferably, the solvent may contain condensed polycyclic hydrocarbon. The condensed polycyclic hydrocarbon contained in the solvent can prevent clouding of the solvent which may occur when the adhesive composition is stored in a liquid form (particularly at a low temperature). This can improve product stability.

The hydrocarbon-based solvent can be linear, branched, or cyclic hydrocarbon. Examples of the hydrocarbon solvent include linear hydrocarbons such as hexane, heptane, octane, nonane, methyloctane, decane, undecane, dodecane and tridecane, branched hydrocarbons having 3 to 15 carbon atoms, p-mentane, o-mentane, m-mentane, diphenyl mentane, α-terpinene, β-terpinene, γ-terpinene, 1,4-terpine, 1,8-terpine, bornane, norbornane, pinane, α-pinene, β-pinene, thujane, α-thujone, β-thujone, carane, and longifolene.

Examples of the petroleum-based solvent include cyclohexane, cycloheptane, cyclooctane, naphthalene, decahydronaphthalene and tetrahydronaphthalene.

The condensed polycyclic hydrocarbon is a condensed ring hydrocarbon in which two or more monocycles are fused with each other by commonly sharing one side thereof only. It is preferable that the condensed polycyclic hydrocarbon be a hydrocarbon in which two monocycles are fused with each other.

Examples of the condensed ring hydrocarbon include a hydrocarbon in which a five-membered ring and a six-membered ring are fused with each other and a hydrocarbon in which two six-membered rings are fused with each other. Examples of the hydrocarbon in which the five-membered ring and the six-membered ring are fused with each other include indene, pentalene, indane and tetrahydroindene. Examples of the hydrocarbon in which the two six-membered rings are fused with each other include naphthalene, tetrahydronaphthalene (tetralin) and decahydronaphthalene (decalin).

In a case where the solvent contains the condensed polycyclic hydrocarbon, a component contained in the solvent can be only the condensed polycyclic hydrocarbon or the solvent can include a different component such as, for example, saturated aliphatic hydrocarbon and/or the like. In either case, content of the condensed polycyclic hydrocarbon is preferably 40 parts by weight or more and more preferably 60 parts by weight or more with respect to the weight of the entire hydrocarbon solvent. In a case where the content of the condensed polycyclic hydrocarbon is 40 parts by weight or more with respect to the weight of the entire hydrocarbon solvent, it is possible to exhibit a high solubility for the resin. In a case where a ratio of the condensed polycyclic hydrocarbon and the saturated aliphatic hydrocarbon is controlled within either of the above content range, it is possible to moderate an odor of the condensed polycyclic hydrocarbon.

Examples of the saturated aliphatic hydrocarbon include linear hydrocarbons such as hexane, heptane, octane, nonane, methyloctane, decane, undecane, dodecane and tridecane, branched hydrocarbons having 3 to 15 carbon atoms, p-mentane, o-mentane, m-mentane, diphenyl mentane, 1,4-terpine, 1,8-terpine, bornane, norbornane, pinane, thujane, carane, and longifolene.

A content of the solvent in the adhesive composition of the invention is adjusted as appropriate in accordance with a thickness of the adhesive layer which is formed by use of the adhesive composition. For example, if the total amount of the adhesive composition is 100 parts by weight, then it is preferable that the content of the solvent be in a range of 20 parts by weight to 90 parts by weight. In a case where the content of the solvent is controlled within the above range, it is possible to easily perform viscosity control.

### (Thermal polymerization inhibitor)

In the invention, the adhesive composition can contain a thermal polymerization inhibitor. The thermal polymerization inhibitor has a function to inhibit a radical polymerization reaction induced by heating. Specifically, because the thermal polymerization inhibitor has a high reactivity to a radical, a reaction of the thermal polymerization inhibitor with the radical predominates the reaction with the monomers, thereby inhibiting polymerization of the monomers. Therefore, in the adhesive composition in which the thermal polymerization inhibitor is contained, a polymerization reaction is inhibited under a high temperature condition (particularly, at a temperature in a range of 250°C to 350°C).

In a manufacturing process of a semiconductor, for example, there is a high-temperature process in which the wafer to which the support plate (support) is bonded is heated at a temperature of 250°C for 1 hour. If a polymerization reaction occurs in the adhesive composition by the high temperature during the high temperature process, the polymerization results in a decrease in solubility of the adhesive composition with respect to a stripping solution which is used to peel off the support plate from the wafer after the high temperature process. This makes it impossible to suitably peel off the support plate from the wafer. In contrast, in the adhesive composition of the invention in which the thermal polymerization inhibitor is contained, heat-induced oxidation and polymerization reaction associated therewith are prevented from occurring. As such, even after the high temperature process, it is still possible to easily peel off the support plate from the wafer, and thereby preventing a residue from generating.

The thermal polymerization inhibitor is not particularly limited as long as it is effective in preventing heat-induced radical polymerization reaction. It is preferable that the thermal polymerization inhibitor be a thermal polymerization inhibitor containing phenol. By using the thermal polymerization inhibitor containing phenol, it is possible to maintain a good solubility even after the high temperature process is carried out under an atmosphere pressure. For example, the thermal polymerization inhibitor containing phenol can be pyrogallol, benzoquinone, hydroquinone, methylene blue, tert-butylcatechol, monobenzyl ether, methylhydroquinone, amylquinone, amyloxyhydroquinone, n-butylphenol, phenol, hydroquinone monopropyl ether, 4,4'-(1-methylethylidene)bis(2-methylphenol), 4,4'-(1-methylethylidene)bis(2,6-dimethylphenol), 4,4'-{1-[4-(1-(4-hydroxyphenyl)-1-methylethyl)phenyl]ethylidenelbisphenol, 4,4',4' - ethylidenetris(2-methylphenol), 4,4',4' - ethylidenetrisphenol, 1,1,3-tris(2,5-dimethyl-4-hydroxyphenyl)-3-phenylpropane, 2,6-di-tert-butyl-4-methylphenol, 2,2'-methylenebis(4-methyl-6-tertbutylphenol), 4,4'-butylidenebis(3-methyl-6-tertbutylphenol), 4,4'-thiobis(3-methyl-6-tert-butylphenol), 3,9-bis[2-(3-(3-tert-butyl-4-hydroxy-5-methylphenyl)-propionyloxy)-1,1-dimethylethyl]-2,4,8,10-tetraoxaspiro(5,5)undecane, triethyleneglycol-bis-3-(3-tert-butyl-4-hydroxy-5-methylphenyl)propionate, n-octyl-3-(3,5-di-tert-butyl-4-hydroxyphenyl)propionate, pentaerythritol-tetrakis-[3-(3,5-di-tert-butyl-4-hydroxyphenyl)propionate] (product name: IRGANOX1010, manufactured by Chiba JAPAN Co., Ltd.), tris(3,5-di-tert-butylhydroxybenzil)isocyanurate, or thiodiethylenebis[3-(3,5-di-tert-butyl-4-hydroxyphenyl)propionate]. The thermal polymerization inhibitor can be used as one thermal polymerization inhibitor or a combination of two or more thermal polymerization inhibitors.

A content of the thermal polymerization inhibitor is determined as appropriate in accordance with a type of the elastomer, use of the adhesive composition, and an environment in which the adhesive composition is used. For example, if a content of the elastomer is 100 parts by weight, then it is preferable that the content of the thermal polymerization inhibitor be in a range of 0.1 parts by weight to 10 parts by weight. In a case where the content of the thermal polymerization inhibitor is set within the above range, it is possible to exhibit a suitable thermal polymerization inhibition effect. This can further reduce the decrease in the adhesive composition's solubility in the stripping solution used after the high-temperature process.

The adhesive composition of the invention can contain an entrainer in which the thermal polymerization inhibitor is dissolved and whose composition is different from a composition of the solvent for dissolving the elastomer. The entrainer is not particularly limited and can be an organic solvent in which components included in the adhesive composition are dissolved.

For example, the organic solvent may be used as one organic solvent or a combination of two or more organic solvents, provided that the organic solvent can dissolve the components of the adhesive composition so as to produce a uniform solution.

A specific example of the organic solvent includes a terpene solvent including an oxygen atom, a carbonyl group or an acetoxy group as a polar group. For example, the organic solvent can be geraniol, nerol, linalool, citral, citronellol, menthol, isomenthol, neomenthol, α-terpineol, β-terpineol, γ-terpineol, terpinene-1-ol, terpinene-4-ol, dihydroterpinylacetate, 1,4-cineol, 1,8-cineol, borneol, carvone, ionone, thujone, or camphor. Alternatively, the organic solvent can be lactones such as γ-butyrolactone or the like, ketones such as acetone, methylethylketone, cyclohexanone (CH), methyl-n-pentylketone, methylisopentylketone or 2-heptanone, polyalcohols such as ethyleneglycol, diethyleneglycol, propyleneglycol or dipropyleneglycol, compounds having a ester bonding such as ethyleneglycol monoacetate, diethyleneglycol monoacetate, propyleneglycol monoacetate or dipropyleneglycol monoacetate, monoalkyl ether of the polyalcohol or the compound having the ester bonding, such as monomethyl ether, monoethyl ether, monopropyl ether, monobutyl ether, a derivative of a polyalcohol such as compounds having an ether bonding, such as monophenyl ether (among them, propyleneglycol monomethyl ether acetate (PGMEA), propyleneglycol monomethyl ether (PGME) are preferable), cyclic ethers such as dioxane, esters such as methyl lactate, ethyl lactate (EL), methyl acetate, ethyl acetate, butyl acetate, methyl pyruvate, ethyl pyruvate, methyl methoxypropionate or ethyl ethoxypropionate, or an aromatic-based organic solvent such as anisole, ethylbenzil ether, cresylmethyl ether, diphenyl ether, dibenzyl ether, phenetol or butylphenyl ether.

A content of the entrainer is determined as appropriate in accordance with a type of the thermal polymerization inhibitor and/or the like. For example, if the content of the thermal polymerization inhibitor is 1 part by weight, then the content of the entrainer is preferably in a range of 1 part by weight to 50 parts by weight, more preferably in a range of 1 part by weight to 30 parts by weight, and most preferably in a range of 1 part by weight to 15 parts by weight. In a case where the content of the thermal polymerization inhibitor is set within the either range, it is possible to fully dissolve the thermal polymerization inhibitor.

### (Another component)

The adhesive composition can further include another miscible substance in such a range that no essential feature of the invention is impaired. For example, the adhesive composition can further include a conventional additive used to improve performance of an adhesive, such as an additive resin, a plasticizer, an adhesion auxiliary substance, a stabilizer, a colorant, a surfactant and/or the like.

### (Method for preparing adhesive composition)

A method for preparing the adhesive composition of the invention is not particularly limited and can be a known method. For example, the adhesive composition of the invention can be obtained by dissolving the elastomer in the solvent and stirring them by using an existing stirrer device.

In a case where the thermal polymerization inhibitor is added to the adhesive composition of the invention, it is preferable to add the thermal polymerization inhibitor, which was dissolved in advance in the entrainer for dissolving the thermal polymerization inhibitor, to the adhesive composition of the invention.

### [Use of the adhesive composition according to the invention]

The adhesive composition according to the invention is used for bonding a wafer and a support for the wafer.

For example, the support is a member which supports a wafer during the thinning process of the wafer and is bonded to the wafer by use of the adhesive composition of the invention. In the embodiment, for example, the support is formed of glass or silicon of which the film thickness is in a range of 500 **µ**m to 1,000 **µ**m.

In the embodiment, the support has a through-hole penetrating in a thickness direction of the support. By pouring the solvent which dissolves the adhesive composition in between the support and the wafer through the through-hole, it is possible to easily separate the support and the substrate.

In another embodiment, a reaction layer in addition to an adhesive layer may be provided between a support and a wafer. The reaction layer is changed in quality by absorbing light irradiated through the support. By changing the reaction layer in quality by irradiating light or the like thereto, it is possible to easily separate the support from the wafer. In this case, it is preferable to use, as the support, a support having no through-hole penetrating in a thickness direction of the support.

As the light irradiated to the reaction layer, laser lights such as solid-state lasers including a YAG laser, a ruby laser, a glass laser, a YVO₄ laser, an LD laser, a fiber laser and the like, liquid lasers including a dye laser and the like, gas lasers including a CO₂ laser, an excimer laser, an Ar laser, a He-Ne laser and the like, a semiconductor laser and a free electron laser, or non-laser lights may be used as appropriate in accordance with the wavelength which can be absorbed by the reaction layer. For example, the wavelength of light to be absorbed by the reaction layer may be a wavelength of equal to or less than 600 nm, but it is not limited thereto.

The reaction layer may contain, for example, a light absorbent which is decomposed by light or the like. Examples of the light absorbent include pigments and dyes such as fine particle metal powders such as graphite powder, iron, aluminum, copper, nickel, cobalt, manganese, chrome, zinc and tellurium, metal oxide powders such as black titanium oxide and the like, carbon black, an aromatic diamine-based metal complex, an aliphatic diamine-based metal complex, an aromatic dithiol-based metal complex, a mercaptophenol-based metal complex, a squarylium-based compound, a cyanine-based pigment, a methine-based pigment, a naphthoquinone-based pigment and an anthraquinone-based pigment. The reaction layer can be formed by, for example, applying a mixture of the light absorbent and a binder resin onto the support. A resin having a light absorbing group can be used.

The reaction layer can be an inorganic or organic film formed by a plasma CVD method. For example, as the inorganic film, a metal film can be used. In addition, as the organic film, a fluorocarbon film can be used. The reaction film can be formed on the support by, for example, a plasma CVD method.

In addition, the adhesive composition according to the invention is suitably used for adhesion of a wafer subjected to a thinning process after being bonded to a support and the support. As described above, the support holds the strength of a wafer when the wafer is thinned. The adhesive composition according to the invention is suitably used for bonding such a wafer and support.

In addition, since the adhesive composition according to the invention has excellent heat resistance, the adhesive composition is suitably used for adhesion of a wafer exposed under an environment of equal to or higher than 150°C after bonded to a support and the support. Specifically, it can be also suitably used under an environment of equal to or higher than 180°C, and further, equal to or higher than 220°C.

For example, in a case where a through electrode is formed in a wafer, one that the wafer and the support are bonded to each other is exposed to an environment of equal to or higher than 150°C. Even the adhesive layer exposed to such an environment, since the adhesive layer formed of the adhesive composition according to the invention is easily dissolved in solvents, a wafer and a support are easily separated. Moreover, the styrene content and the elastomer having a weight average molecular weight in the above range are contained in the adhesive composition according to the invention, and thus it is possible to inhibit occurrence of the film stress when heating the adhesive layer, and as a result, it is possible to inhibit generation of warpage.

Moreover, a method for manufacturing a laminate comprising bonding a wafer and a support with the adhesive composition according to the invention, a method for thinning a wafer of the laminate, and a method for heating the laminate at a temperature of equal to or higher than 150°C are also within the scope of the invention.

### [Removal of adhesive layer formed of adhesive composition]

In a case where the adhesive layer is removed after a wafer and a support which were bonded to each other with the adhesive composition according to the invention are separated by changing the reaction layer in quality, the adhesive layer can easily removed by dissolving with the solvent. In addition, without using the reaction layer, by directly supplying the solvent to the adhesive layer in a state of bonding a wafer and a support, the adhesive layer is easily dissolved and removed, and the wafer and the support can be easily separated. In this case, it is more preferable that a though-hole be provided in the support to increase supply efficiency of a solvent to the adhesive layer.

### [Adhesive film]

The adhesive composition of the invention can be used in various ways in accordance with the use. For example, the adhesive composition can be used in a method in which the adhesive layer is formed by applying the adhesive composition in a liquid form on a work object of a semiconductor wafer and the like, or a method (adhesive film method) in which the adhesive film of the invention is attached to a work object. According to the adhesive film method, the adhesive film of the invention is prepared in advance by forming the adhesive layer of the adhesive composition described above, on a film, such as a flexible film, and drying the adhesive film thus formed.

The adhesive film of the invention thus includes the adhesive layer which contains the adhesive composition and formed on the film.

The adhesive layer of the adhesive film may be covered with a protecting film. In this case, the adhesive layer is uncovered by peeling the protecting film, the adhesive layer thus uncovered is stacked on the work object, and the film is peeled off from the adhesive layer. In this way, it is possible to easily form the adhesive layer on the work object.

Therefore, by use of the adhesive film, it is possible to provide the adhesive layer whose film thickness uniformity and surface smoothness are excellent as compared with an adhesive layer formed by applying the adhesive composition directly on the work object.

The film thus used in preparation of the adhesive film is not particularly limited, as long as the film is a release film which can be peeled off from the adhesive layer formed on a film so as to allow transferring of the adhesive layer from the adhesive film onto a work surface of the work object such as a protecting substrate or a wafer. For example, the film can be a flexible film which is made of a synthetic-resin film containing polyethylene terephthalate, polyethylene, polypropylene, polycarbonate or polyvinyl chloride whose film thickness is in a range of 15 **µ**m to 125 **µ**m. It is preferable that the film be subjected to a release process if necessary, so as to make transferring of the adhesive layer easy.

The method in which the adhesive layer is formed on the film may be a method in which the adhesive layer is formed by applying the adhesive composition of the invention on the film at a thickness that will be in a range of 10 **µ**m to 1,000 **µ**m after drying, in which the adhesive composition of the invention may be applied as appropriate in consideration of a desired film thickness and uniformity of the adhesive layer and the application may be performed by using a known method.

In a case where the protecting film is used, the protecting film is not limited as long as it can be peeled off from the adhesive layer. For example, it is preferable that the protecting film be a polyethylene terephthalate film, a polypropylene film, or a polyethylene film. Further, it is preferable that the protecting film be subjected to a silicone coating process or a silicon baking process. This is because the protecting film subjected to the silicon coating process or the silicon baking process can be easily peeled off from the adhesive layer. A thickness of the protecting film is preferably, but not particularly limited to, in a range of 15 **µ**m to 125 **µ**m. This is because in a case where the thickness of the protecting film is set within the above range, it is possible to prevent the protecting film in the adhesive film from hindering flexibility of the adhesive film.

The method in which the adhesive film is used is not limited to a particular method. For example, in a case where the protecting film is used, a thermal compression method can be used. According to the thermal compression method, the adhesive layer is uncovered by peeling the protecting film, stacked on the work object, and thermally compressed on the work object by moving a heating roller on the film (a surface opposite to a surface on which the adhesive layer is formed). After peeling, it is optional to sequentially reel the protecting film in a roll form by using a roller such as a reel roller. In this case, the protecting film can be stored and reused.

### [Laminate]

The laminate according to the invention is formed by laminating a wafer, an adhesive layer formed of the adhesive composition according to the invention, and a support in this order. Since a wafer and a support are laminated through the adhesive layer formed of the adhesive composition according to the invention, it is easy to dissolve the adhesive layer, and it is easy to peel off the wafer and the support. Moreover, description of the support, and the adhesive composition according to the invention conforms to the above description.

In addition, the laminate according to the invention more preferably further includes a release layer which is changed in quality by absorbing light between the adhesive layer and the support. With change of the release layer in quality by irradiating light, a wafer and a support are more easily peeled.

### [Release layer]

The release layer is a layer formed of a material which is changed in quality by absorbing light irradiated through a support. In the specification, "change in quality" of the release layer refers to a phenomenon in which the release layer becomes a state in which the release layer may be broken in response to a slight external force, or the adhesive force with the layers in contact with the release layer is decreased. As a result of change in quality of the release layer generated by absorbing light, the release layer loses the strength or the adhesiveness before being irradiated with light. Therefore, by applying a slight external force (for example, lifting the support), the release layer is broken, and thus it is possible to easily separate the support and the wafer.

In addition, change of the release layer in quality can be (pyrogenic or non-pyrogenic) decomposition, crosslinking, change in a configuration or dissociation of functional groups (and hardening, degasification, contraction or expansion of the release layer associated with these) due to the energy of the absorbed light. The change of the release layer in quality occurs as a result of the absorption of light by a material constituting the release layer. Thus, the type of the change of the release layer in quality can vary depending on the type of a material constituting the release layer.

The release layer is provided on the surface of the side of the support where the wafer is attached through the adhesive layer. That is, the release layer is provided between the support and the adhesive layer.

For example, the thickness of the release layer is preferably 0.05 **µ**m to 50 **µ**m, and more preferably 0.3 **µ**m to 1 **µ**m. When the thickness of the release layer is within the range of 0.05 **µ**m to 50 **µ**m, a desired change in quality can be generated at the release layer by irradiation with light for a short time and irradiation with light having low energy. In addition, the thickness of the release layer is particularly preferably within the range of equal to or less than 1 **µ**m from the viewpoint of productivity.

Moreover, in the laminate, other layers may be further formed between the release layer and the support. In this case, the other layers may be constituted by a material which transmits light. Thus, it is possible to suitably add a layer which applies desirable properties to the laminate without preventing the incidence of light into the release layer. The wavelength of light which can be used is different depending on the type of material constituting the release layer. Thus, the material constituting the other layers can be suitably selected from materials which can transmit light having a wavelength that can change materials constituting the release layer in quality, however, the materials are not required to transmit all light.

In addition, the release layer is preferably formed of only material having a structure which absorbs light, and it is also possible to form the release layer by adding a material not having a structure which absorbs light in such a range where no essential feature of the invention is impaired. In addition, a surface of the side opposite to the adhesive layer in the release layer is preferably flat (irregularities are not formed). Thus, it is possible to easily perform formation of the release layer, and uniformly attach at the time of adhesion.

As the release layer, a layer in which a material constituting the release layer as shown below is formed into a film shape, and then, attached to the support in advance may be used, and a layer in which a material constituting the release layer is coated on the support, and then, solidified in a film shape may be used. A method for applying a material constituting the release layer on the support can be suitably selected from methods known in the related art such as a chemical vapor deposition (CVD) method in accordance with the type of the material constituting the release layer.

The release layer may be changed in quality by absorbing light irradiated from a laser. That is, light irradiated to the release layer in order to change the release layer in quality may be one that is irradiated from the laser. As a laser for emitting light which is irradiated to the release layer, solid-state lasers including a YAG laser, a ruby laser, a glass laser, a YVO₄ laser, an LD laser, a fiber laser and the like, liquid lasers including a dye laser and the like, gas lasers including a CO₂ laser, an excimer laser, an Ar laser, a He-Ne laser and the like, a semiconductor laser and a free electron laser, or non-laser lights can be exemplified. A laser for emitting light which is irradiated to the release layer can be suitably selected depending on materials constituting the release layer, and a laser that emits light having a wavelength that can change materials constituting the release layer in quality may be selected.

### (Polymer containing structure having light absorption properties in repeating unit thereof)

The release layer may contain a polymer containing a structure having light absorption properties in the repeating unit. The polymer is changed in quality by irradiation of light. The change of the polymer in quality is generated since the structure absorbs light irradiated. As a result of the change of the polymer in quality, the release layer loses the strength and the adhesiveness before being irradiated with light. Therefore, by applying a slight external force (for example, lifting the support), the release layer is broken, and thus it is possible to easily separate the support and the wafer.

The structure having light absorption properties is a chemical structure that changes the polymer in quality that absorbs light and contains the structure as a repeat unit. For example, the structure is an atomic group containing a conjugated π-electron system formed of a substituted benzene ring or an unsubstituted benzene ring, a condensed ring or a heterocyclic ring. In more detail, the structure may be a cardo structure, a benzophenone structure present at the side chain of the polymer, diphenyl sulfoxide structure, diphenyl sulfone structure (bis-phenyl sulfone structure), diphenylamine structure or diphenyl structure.

In a case where the structure is present at the side chain of the polymer, the structure can be represented by the following formulas.

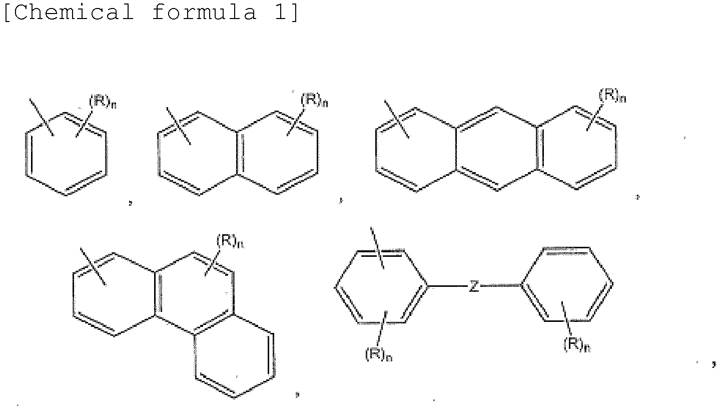

In the formulas, R each independently represents an alkyl group, an aryl group, a halogen, a hydroxyl group, a ketone group, a sulfoxide group, a sulfone group or N(R₁)(R₂) (where R₁ and R₂ each independently represent a hydrogen atom or an alkyl group having 1 to 5 carbon atoms), Z is absent or represents -CO-, -SO₂-, -SO- or-NH-, and n represents 0 or an integer of 1 to 5.

In addition, for example, the polymer contains a repeating unit represented by any one of (a) to (d), is represented by (e), or contains a structure of (f) in the main chain, among the following formulas.

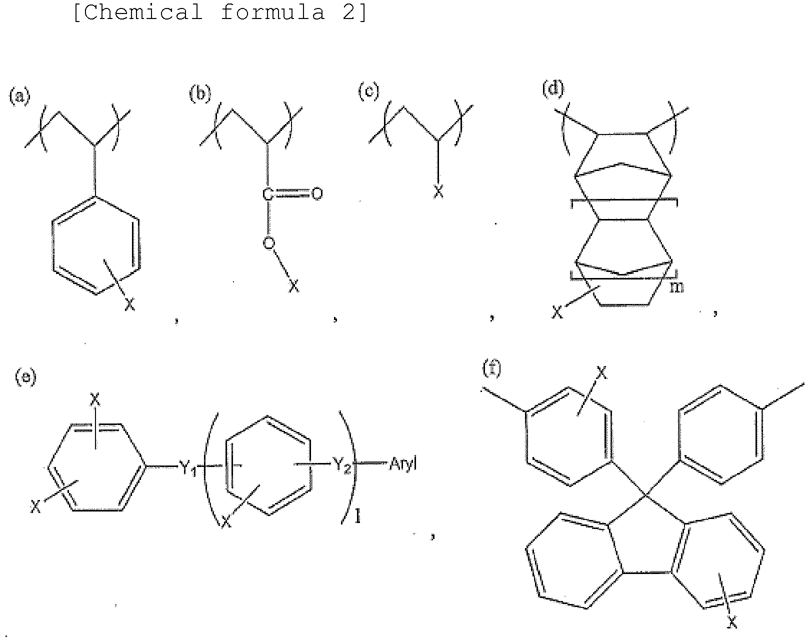

In the formulas, 1 is an integer of equal to or greater than 1, m is an integer of 0 or 1 to 2, X is any one of the formulas shown in "Chemical formula 1" described above in (a) to (e), any one of the formulas shown in "Chemical formula 1" described above in (f), or is absent, and Y₁ and Y₂ represent each independently -CO- or -SO₂-. 1 is preferably an integer of equal to or less than 10.

Examples of a benzene ring, a condensed ring and a heterocyclic ring shown in "Chemical formula 1" described above include phenyl, substituted phenyl, benzyl, substituted benzyl, naphthalene, substituted naphthalene, anthracene, substituted anthracene, anthraquinone, substituted anthraquinone, acridine, substituted acridine, azobenzene, substituted azobenzene, fluorim, substituted fluorim, fluorimon, substituted fluorimon, carbazole, substituted carbazole, N-alkylcarbazole, dibenzofuran, substituted dibenzofuran, phenanthrene, substituted phenanthrene, pyrene and substituted pyrene. In a case where the exemplified substituent has a substitution, for example, the substituent can be selected from alkyl, aryl, a halogen atom, alkoxy, nitro, aldehyde, cyano, amide, dialkylamino, sulfonamide, imide, carboxylic acid, carboxylic ester, sulfonic acid, sulfonic ester, alkylamino and arylamino.

Among the substituents shown in "Chemical formula 1" described above, examples of a case where a substituent is a fifth substituent having two phenyl groups, and Z is - SO₂- include bis(2,4-dihydroxyphenyl)sulfone, bis(3,4-dihydroxyphenyl)sulfone, bis(3,5-dihydroxyphenyl)sulfone, bis(3,6-dihydroxyphenyl)sulfone, bis (4-hydroxyphenyl)sulfone, bis(3-hydroxyphenyl)sulfone, bis(2-hydroxyphenyl)sulfone, and bis(3,5-dimethyl-4-hydroxyphenyl)sulfone.

Among the substituents shown in "Chemical formula 1" described above, examples of a case where a substituent is a fifth substituent having two phenyl groups, and Z is - SO- include, bis(2,3-dihydroxyphenyl)sulfoxide, bis(5-chloro-2,3-dihydroxyphenyl)sulfoxide, bis(2,4-dihydroxyphenyl)sulfoxide, bis(2,4-dihydroxy-6-methylphenyl)sulfoxide, bis(5-chloro-2,4-dihydroxyphenyl)sulfoxide, bis(2,5-dihydroxyphenyl)sulfoxide, bis(3,4-dihydroxyphenyl)sulfoxide, bis(3,5-dihydroxyphenyl)sulfoxide, bis(2,3,4-trihydroxyphenyl)sulfoxide, bis(2,3,4-trihydroxy-6-methylphenyl)-sulfoxide, bis(5-chloro-2,3,4-trihydroxyphenyl)sulfoxide, bis(2,4,6-trihydroxyphenyl)sulfoxide, bis(5-chloro-2,4,6-trihydroxyphenyl)sulfoxide.

Among the substituents shown in "Chemical formula 1" described above, examples of a case where a substituent is a fifth substituent having two phenyl groups, and Z is - C(=O)- include, 2,4-dihydroxybenzophenone, 2,3,4-trihydroxybenzophenone, 2,2',4,4'-tetrahydroxybenzophenone, 2,2',5,6'-tetrahydroxybenzophenone, 2-hydroxy-4-methoxybenzophenone, 2-hydroxy-4-octoxybenzophenone, 2-hydroxy-4-dodecyloxybenzophenone, 2,2'-dihydroxy-4-methoxybenzophenone, 2,6-dihydroxy-4-methoxybenzophenone, 2,2'-dihydroxy-4,4'-dimethoxybenzophenone, 4-amino-2'-hydroxybenzophenone, 4-dimethylamino-2'-hydroxybenzophenone, 4-diethylamino-2'-hydroxybenzophenone, 4-dimethylamino-4'-methoxy-2'-hydroxybenzophenone, 4-dimethylamino-2',4'-dihydroxybenzophenone, and 4-dimethylamino-3',4'-dihydroxybenzophenone.

In a case where the structure is present at the side chain of the polymer, a proportion occupied by the repeating unit containing the structure in the polymer is in a range in which light transmittance of the release layer becomes 0.001% to 10%. When a polymer is prepared such that the proportion is within the range, the release layer sufficiently absorbs light, and thus the polymer can be reliably and quickly changed in quality. That is, it is easy to remove the support from the laminate, and it is possible to reduce a light irradiation time required for the removal.

The structures can absorb light having a wavelength in the desired range by selection of the type. For example, the wavelength of light that can be absorbed by the structure is preferably 100 nm to 2,000 nm. In the range, the wavelength of light that can be absorbed by the structure is close to short wavelength, and for example, the wavelength is 100 nm to 500 nm. For example, preferably, by absorbing ultraviolet rays having a wavelength of about 300 nm to 370 nm, the structure can change a polymer containing the structure in quality.

Examples of the light that can be absorbed by the structure are lights emitted from a high-pressure mercury lamp (wavelength: 254 nm to 436 nm), a KrF excimer laser (wavelength: 248 nm), an ArF excimer laser (wavelength: 193 nm), an F₂ excimer laser (wavelength: 157 nm), a XeCl laser (308 nm), a XeF laser (wavelength: 351 nm) or a solid-state UV laser (wavelength: 355 nm), or a g-ray (wavelength: 436 nm), a h-ray (wavelength: 405 nm) or an i-ray (wavelength: 365 nm).

The release layer contains a polymer including the structure as a repeating unit, and the release layer can further contain components other than the polymer. Examples of the components include a filler, a plasticizer, and components that can improve the release properties of the support. These components are suitably selected from substances or materials known in the related art which do not inhibit absorption of light by the structure, and not inhibit or promote change of the polymer in quality.

### (Inorganic substance)

The release layer may be formed of an inorganic substance. By being constituted with an inorganic substance, the release layer is changed in quality by absorbing light, and as a result, the release layer loses the strength or the adhesiveness before being irradiated with light. Therefore, by applying a slight external force (for example, lifting the support), the release layer is broken, and thus it is possible to easily separate the support and the wafer.

The inorganic substance may be a constitution which is changed in quality by absorbing light. For example, an inorganic substance of one or more types selected from the group consisting of a metal, a metal compound and carbon can be suitably used. The metal compound refers to a compound containing a metal atom, and for example, the metal compound can be metal oxides, metal nitrides. Examples of the inorganic substance include an inorganic substance of one or more types selected from the group consisting of gold, silver, copper, iron, nickel, aluminum, titanium, chromium, SiO₂, SiN, Si₃N₄, TiN and carbon, but the inorganic substance is not limited thereto. Moreover, the carbon can also include allotrope of carbon, and examples of the carbon include a diamond, fullerene, diamond-like carbon, a carbon nanotube.

The inorganic substance absorbs light having a wavelength in the specific range depending on the type. By irradiating light having a wavelength in the range that the inorganic substance used in the release layer absorbs to the release layer, the inorganic substance is suitably changed in quality.

As the light irradiated to the release layer formed of inorganic substances, laser lights such as solid-state lasers including a YAG laser, a ruby laser, a glass laser, a YVO₄ laser, an LD laser, a fiber laser and the like, liquid lasers including a dye laser and the like, gas lasers including a CO₂ laser, an excimer laser, an Ar laser, a He-Ne laser and the like, a semiconductor laser and a free electron laser, or non-laser lights may be used as appropriate in accordance with the wavelength which can be absorbed by the inorganic substances.

The release layer formed of the inorganic substance can be formed on the support, for example, by known techniques such as sputtering, chemical vapor deposition (CVD), plating, plasma CVD, spin coating. The thickness of the release layer formed of an inorganic substance is not particularly limited, and it may be a thickness that can sufficiently absorb the light to be used. For example, a film thickness of 0.05 **µ**m to 10 **µ**m is more preferable. In addition, after both sides or one side of an inorganic film (for example, a metal film) formed of an inorganic substance constituting the release layer is coated with an adhesive in advance, adhesion may be performed to the support and the wafer.

In a case where a metal film is used as a release layer, reflection of the laser or charging to the film may occur depending on the conditions such as the film quality of the release layer, a type of a laser source, and a laser output. For this reason, it is preferable to take countermeasures for these problems by providing an antireflection film or an antistatic film on and beneath or any one side of the release layer.

### (Compound having structure with infrared ray absorption property)

The release layer may be formed of a compound having a structure with infrared ray absorption property. The compound changes in quality by absorbing the infrared rays. As a result of change of the compound in quality, the release layer loses the strength and the adhesiveness before being irradiated with infrared rays. Therefore, by applying a slight external force (for example, lifting the support), the release layer is broken, and thus it is possible to easily separate the support and the wafer.

Examples of the compounds including a structure having infrared ray absorption property and a structure having infrared ray absorption property include alkane, alkene (vinyl, trans, cis, vinylidene, trisubstituted, tetrasubstituted, conjugated, cumulene, cyclo), alkyne (monosubstituted, disubstituted), a monocyclic aromatic group (benzene, monosubstituted, disubstituted, trisubstituted), alcohols and phenols (free OH, intramolecular hydrogen bond, intermolecular hydrogen bond, saturated secondary, saturated tertiary, unsaturated secondary, unsaturated tertiary), acetal, ketal, aliphatic ether, aromatic ether, vinyl ether, oxirane ring ether, ether peroxides, ketone, dialkyl carbonyl, aromatic carbonyl, enol of 1,3-diketone, o-hydroxy aryl ketone, dialkyl aldehyde, aromatic aldehyde, carboxylic acid (dimer, carboxylate anion), formic acid ester, acetic acid ester, conjugated ester, non-conjugated ester, aromatic ester, lactone (β-, γ-, δ-), aliphatic acid chloride, aromatic acid chloride, acid anhydride (conjugated, non-conjugated, cyclic, acyclic), primary amide, secondary amide, lactam, primary amine (aliphatic, aromatic), secondary amine (aliphatic, aromatic), tertiary amine (aliphatic, aromatic), primary amine salt, secondary amine salt, tertiary amine salt, ammonium ion, aliphatic nitrile, aromatic nitrile, carbodiimide, aliphatic isonitrile, aromatic isonitrile, isocyanic ester, thiocyanic ester, aliphatic isothiocyanic ester, aromatic isothiocyanic ester, aliphatic nitro compounds, aromatic nitro compounds, nitroamine, nitrosoamine, nitric ester, nitrite ester, a nitroso bond (aliphatic, aromatic, monomer, dimer), sulfur compounds such as mercaptan, thiophenol and thiol acid, a thiocarbonyl group, sulfoxide, sulfone, sulfonyl chloride, primary sulfonamide, secondary sulfonamide, sulfuric ester, a carbon-halogen bond, a Si-A¹ bond (A¹ is H, C, O or a halogen), a P-A² bond (A² is H, C or O) or a Ti-O bond.

Examples of the structure including the carbon-halogen bond described above include -CH₂Cl, -CH₂Br, -CH₂I, -CF₂-, -CF₃, -CH=CF₂, -CF=CF₂, aryl fluoride, and aryl chloride.

Examples of the structure including the Si-A¹ bond described above include SiH, SiH₂, SiH₃, Si-CH₃, Si-CH₂-, Si-C₆H_{5,} a SiO aliphatic group, Si-OCH₃, Si-OCH₂CH₃, Si-OC₆H_{5,} Si-O-Si, Si-OH, SiF, SiF₂, and SiF₃. As the structure including the Si-A¹ bond, in particular, a siloxane skeleton and a silsesquioxane skeleton are preferably formed.

Examples of the structure including the P-A² bond described above include PH, PH₂, P-CH₃, P-CH₂-, P-C₆H₅, A³₃-P-O (A³ represents an aliphatic group or an aromatic group), (A⁴O)₃-P-O (A⁴ represents alkyl), P-OCH₃, P-OCH₂CH₃, P-OC₆H₅, P-O-P, P-OH, and O=P-OH.

The above-described structures can absorb infrared rays having a wavelength in the desired range by selecting the type thereof. Specifically, for example, the wavelength of infrared rays that can be absorbed by the structure is in the range of 1 **µ**m to 20 **µ**m, and the structure can more preferably absorb the wavelength in the range of 2 **µ**m to 15 **µ**m. Furthermore, in a case where the structure is a Si-O bond, a Si-C bond and a Ti-O bond, the wavelength can be in the range of 9 **µ**m to 11 **µ**m. Moreover, those skilled in the art can easily understand the wavelength of infrared rays that can be absorbed by each structure. For example, as an absorption band in each structure, pp. 146 to 151 of non-patent literature: "Spectrometric identification of organic compounds - combined use of MS, IR, NMR, UV - (5th edition)", written by Siverstein, Bassler and Morrill (published in 1992) can be referred to.

The compound having a structure with infrared ray absorption property used in the formation of the release layer is not particularly limited as long as it has a structure as described above, can be dissolved in a solvent to be coated, and can be solidified and form a solid layer. However, in order to easily separate the support and the wafer by effectively changing the compound in the release layer in quality, it is preferable that absorption of infrared rays in the release layer be great, that is, the transmittance of infrared rays when the infrared rays are irradiated in the release layer be low. Specifically, the transmittance of infrared rays in the release layer is preferably less than 90%, and the transmittance of infrared rays is more preferably less than 80%.

For example, as the compound having a siloxane skeleton, a resin which is a copolymer having a repeating unit represented by the following Chemical formula (2) and a repeating unit represented by the following Chemical formula (1), or a resin which is a copolymer having a repeating unit represented by the following Chemical formula (1) and a repeating unit derived from acrylic compound can be used.

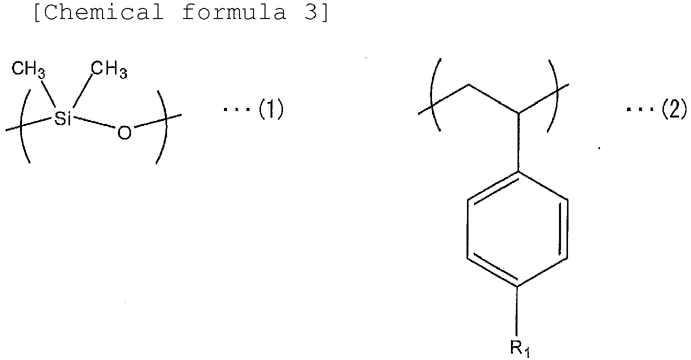

(In the Chemical formula (2), R₁ represents a hydrogen atom, an alkyl group having equal to or less than 10 carbon atoms, or an alkoxy group having equal to or less than 10 carbon atoms)

Among these, as the compound having a siloxane skeleton, tert-butylstyrene (TBST)-dimethylsiloxane copolymer which is a copolymer having a repeating unit represented by the above Chemical formula (1) and a repeating unit represented by the following Chemical formula (3) is more preferable, and TBST-dimethylsiloxane copolymer which includes a repeating unit represented by the above Chemical formula (1) and a repeating unit represented by the following Chemical formula (3) at a ratio of 1:1 is even more preferable.

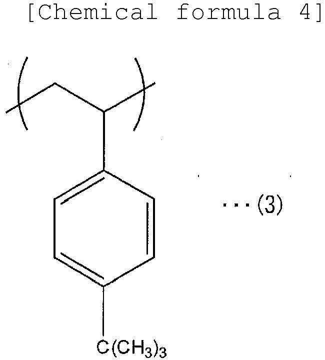

In addition, as the compound having a silsesquioxane skeleton, for example, a resin which is a copolymer having a repeating unit represented by the following Chemical formula (4) and a repeating unit represented by the following Chemical formula (5) can be used.

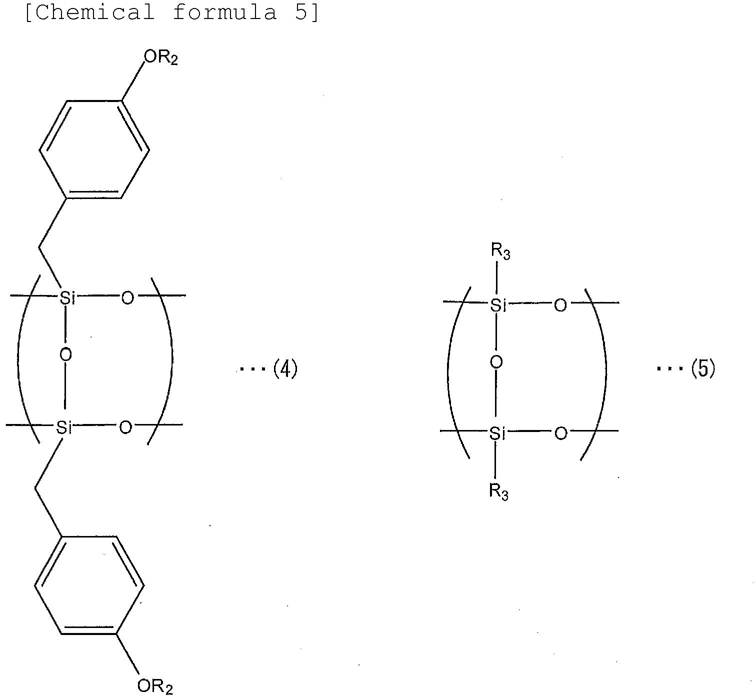

(In Chemical formula (4), R₂ represents a hydrogen atom or an alkyl group having 1 carbon atom to 10 carbon atoms, in Chemical formula (5), R₃ represents an alkyl group having 1 carbon atom to 10 carbon atoms, or a phenyl group)

In addition to the above compounds, as the compound having the silsesquioxane skeleton, each silsesquioxane resin disclosed in Patent Literature 3: JP-A-2007-258663 (published in October 4, 2007), Patent Literature 4: JP-A-2010-120901 (published in June 3, 2010), Patent Literature 5: JP-A-2009-263316 (published in November 12, 2009), and Patent Literature 6: JP-A-2009-263596 (published in November 12, 2009) can be suitably used.

Among these, as the compound having the silsesquioxane skeleton, a copolymer having a repeating unit represented by the following Chemical formula (6) and a repeating unit represented by the following Chemical formula (7) is more preferable, and a copolymer which includes a repeating unit represented by the following Chemical formula (6) and a repeating unit represented by the following Chemical formula (7) at a ratio of 7:3 is even more preferable.

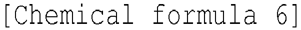

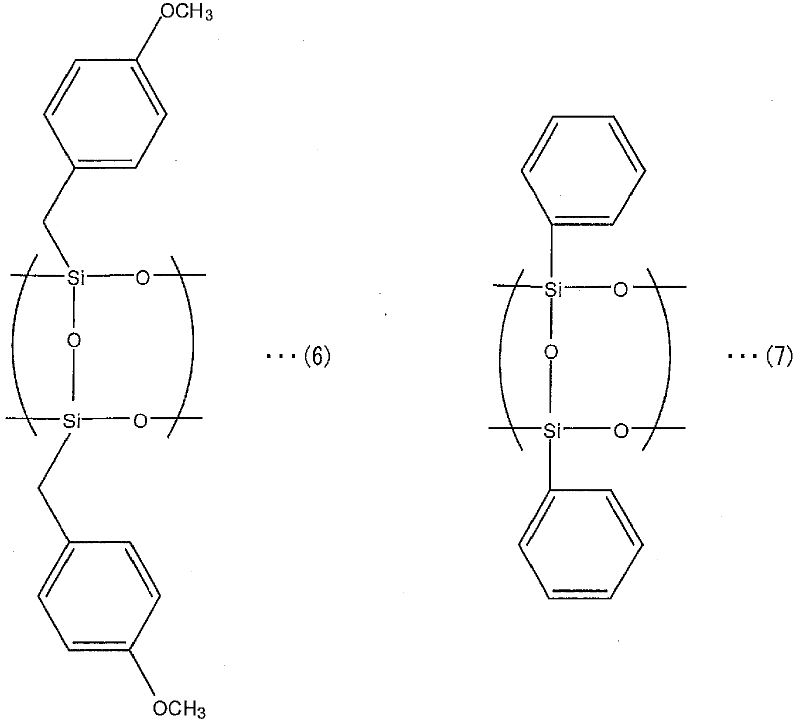

A polymer having the silsesquioxane skeleton can have a random structure, a ladder structure, and a basket structure, and may have any of the structures.

In addition, examples of the compound containing a Ti-O bond include (i) alkoxy titanium such as tetra-i-propoxy titanium, tetra-n-butoxy titanium, tetrakis(2-ethylhexyloxy)titanium and titanium-i-propoxy octylene glycolate, (ii) chelate titanium such as di-i-propoxy bis(acetylacetonato)titanium and propanedioxy titanium bis (ethyl acetoacetate), (iii) titanium polymers such as i-C₃H₇O-[-Ti(O-i-C₃H₇)₂-O-]ₙ-i-C₃H₇ and n-C₄H₉O-[-Ti(O-n-C₄H₉)₂-O-]ₙ-n-C₄H₉, (iv) titanium acylates such as tri-n-butoxy titanium monostearate, titanium stearate, di-i-propoxy titanium diisostearate and (2-n-butoxycarbonyl benzoyloxy)tributoxy titanium, and (v) water-soluble titanium compounds such as di-n-butoxy bis(triethanolaminato)titanium.

Among these, as the compound containing a Ti-O bond, di-n-butoxy-bis(triethanolaminato)titanium (Ti(OC₄H₉)₂[OC₂H₄N(C₂H₄OH)₂]₂) is preferable.

The release layer contains a compound having a structure having infrared ray absorption property, and the release layer can further contain components other than the above-described compounds. Examples of the components include a filler, a plasticizer, and components that can improve the release properties of the support. These components are suitably selected from substances or materials known in the related art which do not inhibit absorption of infrared rays by the structure, and not inhibit or promote change of compounds in quality.

### (Fluorocarbon)

The release layer may be formed of fluorocarbon. By being constituted by the fluorocarbon, the release layer is changed in quality by absorbing light, and as a result, the release layer loses strength or adhesiveness before being irradiated with light. Therefore, by applying a slight external force (for example, lifting the support), the release layer is broken, and thus it is possible to easily separate the support and the wafer.

In addition, from one viewpoint, fluorocarbon constituting the release layer can be suitably film-formed by a plasma CVD method. Moreover, the fluorocarbon includes CₓF_{y} (perfluorocarbon) and CₓH_{y}F_{z} (x, y and z are integers). Examples of the fluorocarbon include CHF₃, CH₂F₂, C₂H₂F₂, C₄F₈, C₂F₆, and C₅F₈, but is not limited thereto. In addition, inert gases such as nitrogen, helium or argon, hydrocarbons such as an alkane and an alkene, oxygen, carbon dioxide, and hydrogen may be added to the fluorocarbon used to constitute a release layer, as necessary. In addition, these gases may be used in a mixture of plural gases (mixed gas of fluorocarbon, hydrogen, and nitrogen). In addition, the release layer may be constituted by single type of fluorocarbon, and the release layer may be constituted by two or more types of fluorocarbons.

The fluorocarbon absorbs light having a wavelength in the specific range depending on the type. By irradiating light having a wavelength in the range that fluorocarbon used in the release layer absorbs, to the release layer, fluorocarbon is suitably changed in quality. The absorptivity of light in the release layer is preferably 80% or more.

As the light irradiated to the release layer, laser lights such as solid-state lasers including a YAG laser, ruby laser, a glass laser, a YVO₄ laser, an LD laser, a fiber laser and the like, liquid lasers including a dye laser and the like, gas lasers including a CO₂ laser, an excimer laser, an Ar laser, a He-Ne laser and the like, a semiconductor laser and a free electron laser, or non-laser lights may be used as appropriate in accordance with the wavelength which can be absorbed by fluorocarbon. As the wavelength that can change fluorocarbon in quality, for example, a wavelength in the range of 600 nm or less can be used, but the wavelength is not limited thereto.

### (Infrared ray absorbing substance)

The release layer may contain an infrared ray absorbing substance. By being constituted so as to contain the infrared ray absorbing substance, the release layer is changed in quality by absorbing light, and as a result, the release layer loses strength or adhesiveness before being irradiated with light. Therefore, by applying a slight external force (for example, lifting the support), the release layer is broken, and thus it is possible to easily separate the support and the wafer.

The infrared ray absorbing substance may be a constitution which is changed in quality by absorbing infrared rays. For example, carbon black, iron particles or aluminum particles can be suitably used. The infrared ray absorbing substance absorbs light having a wavelength in the specific range depending on the type. By irradiating light having a wavelength in the range that the infrared ray absorbing substance used in the release layer absorbs to the release layer, the infrared ray absorbing substance is suitably changed in quality.

### [Example]

### [Preparation of adhesive composition]

Elastomers (resins), a polymerization inhibitor, a main solvent, and an entrainer used in Examples 1 to 9 and Comparative Examples 1 to 4 are shown in Tables 1 and 2 below. Moreover, all "parts" in Tables 1 and 2 are parts by weight.

As the elastomer, Septon 2004 (SEP: polystyrene-poly(ethylene/propylene)block), HG252 (SEEPS-OH: polystyrene-poly(ethylene-ethylene/propylene)block-polystyrene terminal hydroxyl group modified), Septon 4033 (SEPS: polystyrene-poly(ethylene/propylene)block-polystyrene), Septon 8007 (SEBS: polystyrene-poly(ethylene/butylene)block-polystyrene), Septon 2104 (SEPS: polystyrene-poly(ethylene/propylene)block-polystyrene), Septon 4055 (SEEPS: polystyrene-poly(ethylene-ethylene/propylene)block-polystyrene), Septon 4077 (SEEPS: polystyrene-poly(ethylene-ethylene/propylene)block-polystyrene) of Septon (product name) manufactured by KURARAY Co., Ltd., styrene-ethylenebutylene-styrene block copolymer of which the styrene block is a reaction crosslinking type (Septon V9827, which has reactive polystyrene-based hard block (manufactured by KURARAY Co., Ltd.)), MP-10 (SEBS, hydrogenated styrene-based thermoplastic elastomer (terminal amine modified), H1053 (SEBS, hydrogenated styrene-based thermoplastic elastomer), H1043 (SEBS, hydrogenated styrene-based thermoplastic elastomer) of Tuftec (product name) manufactured by Asahi Kasei Corporation were used. Moreover, "hydrogenated" in Examples refers to a polymer obtained by hydrogenating the double bonds of the block copolymer of styrene and butadiene.

Moreover, styrene content and a molecular weight of each elastomer are shown in Tables 1 and 2. A weight average molecular weight was measured by GPC (Gel Permeation Chromatography). The styrene contents are numerical values described in the description supplied with the product.

In addition, as the thermal polymerization inhibitor, "IRGANOX (product name) 1010" manufactured by BASF Corp. was used. In addition, as the main solvent, decahydronaphthalene shown in the following Chemical formula (I) was used. In addition, as the entrainer, butyl acetate was used.

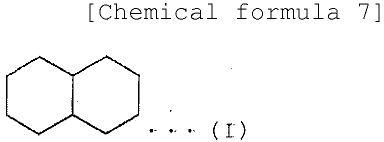

Adjustment of the adhesive composition of Example 1 was performed as follows. First, 100 parts by weight of the elastomer shown in Table 1 was dissolved in 255 parts by weight of the main solvent. Next, a butyl acetate solution of the thermal polymerization inhibitor was added to 100 parts by weight of the elastomer such that the thermal polymerization inhibitor is 1 part by weight, and butyl acetate is 45 parts by weight. Thus, the adhesive composition was obtained. In addition, the adhesive compositions were also obtained in the same manner for Examples 2 to 9 and Comparative examples 1 to 4.

### [Formation of adhesive layer]

Each adhesive composition was spin-coated onto 12-inch silicon wafer, and baked at 100°C, 160°C, and 200°C for 5 minutes each, thereby forming an adhesive layer (thickness: 50 µm).

The results of confirming the warpage of the wafer are as shown in Tables 1 and 2, and in all of Examples and Comparative examples, the warpage was equal to or less than 50 µm at 12 inches.

On the other hand, a reaction layer for peeling off a wafer and a support by changes in quality due to irradiation with a laser later was provided on the support. Under the conditions of a flow rate of 400 sccm, a pressure of 700 mTorr, a high-frequency power of 2500 W and a film-forming temperature of 240°C, by a CVD method using C₄F₈ as a reaction gas, a fluorocarbon film (thickness: 1 µm) which is a release layer was formed on the support (12-inch glass substrate, thickness: 700 µm) as a reaction layer.

In addition, film formability was evaluated by visually observing the presence or absence of cracks. When the cracks were not observed, it was evaluated to be "○", and when the cracks were observed, it was evaluated to be "X". The results are shown in Tables 1 and 2.

In addition, an adhesive strength was also evaluated. As the evaluation of the adhesive strength, in a case of pulling with a force of 2 kg/cm² or more in the vertical direction at 23°C, when the wafer and the support were not peeled, it was evaluated to be "○", and when the wafer and the support were peeled, it was evaluated to be "X". In addition, the results shown as "-" in Tables 1 and 2 mean that measurement of the adhesive strength was not performed since cracks were already formed at the time of film-forming.

### [Thinning of laminate, and high-temperature treatment of laminate]

Using a laminate of a wafer and a support, a thinning of the wafer, a photolithography, a plasma CVD at 220°C, and a heat treatment at 220°C in a N₂ environment were performed. Thus, chemical resistance and heat resistance were evaluated.

As the evaluation of the heat resistance, in a case of performing the plasma CVD for 1 hour, when foaming or peeling did not occur between the wafer and the support, it was evaluated to be "○", and when foaming or peeling occurred between the wafer and the support, it was evaluated to be "X". The results are shown in Tables 1 and 2 (shown as "220°C Vacuum bake" in Tables 1 and 2). In addition, the heat resistance was evaluated also by the heat treatment at 220°C in N₂ environment described above. After the heating treatment was performed for 3 hours, when foaming or peeling did not occur between the wafer and the support, it was evaluated to be "○", and when foaming or peeling occurred between the wafer and the support, it was evaluated to be "X" (shown as "220°C N₂ Cure" in Tables 1 and 2).

As the evaluation of the chemical resistance, using PGMEA, PGME, hydrofluoric acid (HF), tetramethyl ammonium hydroxide (TMAH), the weight change due to decrease of the film of the adhesive layer before and after immersion test (at 23°C for 5 minutes) was measured, and when the weight change did not occur, it was evaluated to be "○", and when the weight change occurred, it was evaluated to be "X". In addition, the results shown as "-" in Table 1 mean that measurement of the resistance test was not performed since cracks were already formed at the time of film-forming.

### [Washing of adhesive layer]

The wafer and the support were separated by being irradiated by a 532 nm laser. The wafer from which the support was removed was spray-washed by use of p-menthane at 23°C, whereby the adhesive layer was removed. The removal rate of the adhesive layer was calculated (the thickness of the adhesive layer which was dissolved per second in the immersion test (nm/sec)). The results are shown in Tables 1 and 2. Moreover, the results shown as "NG" in Table 1 mean that the adhesive layer was not removed.

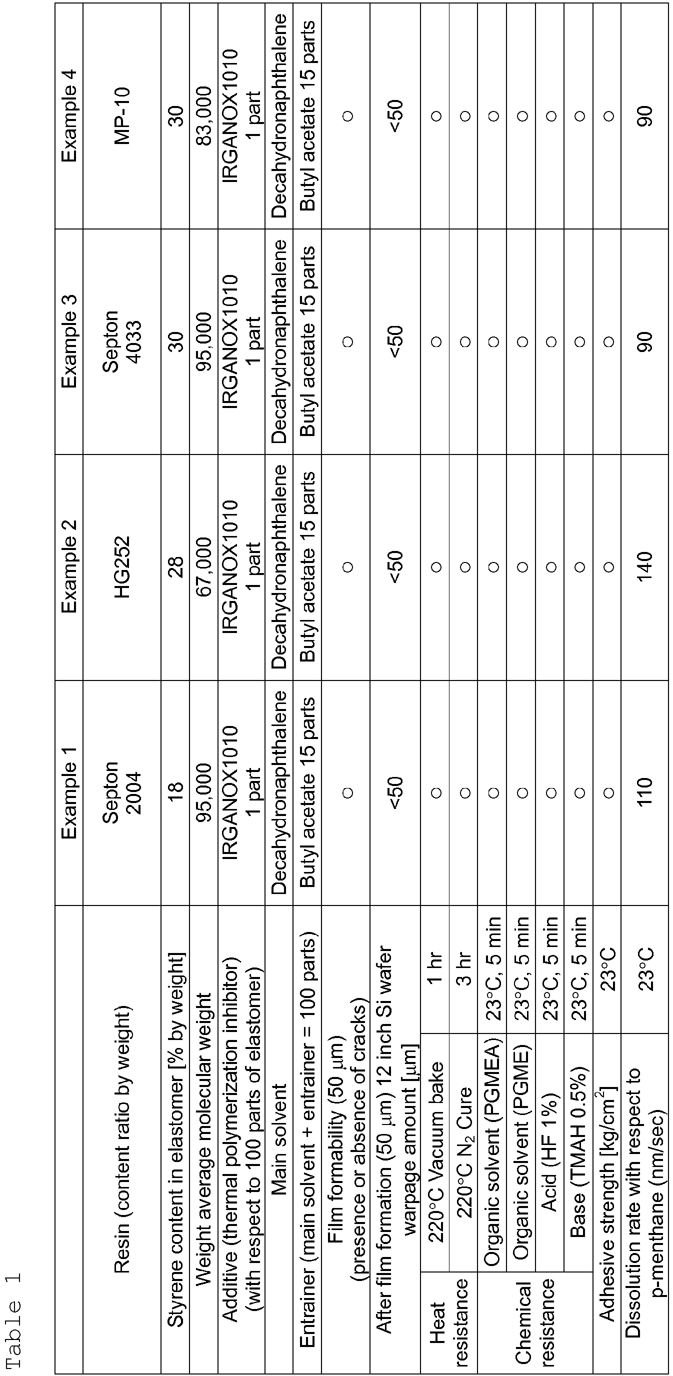

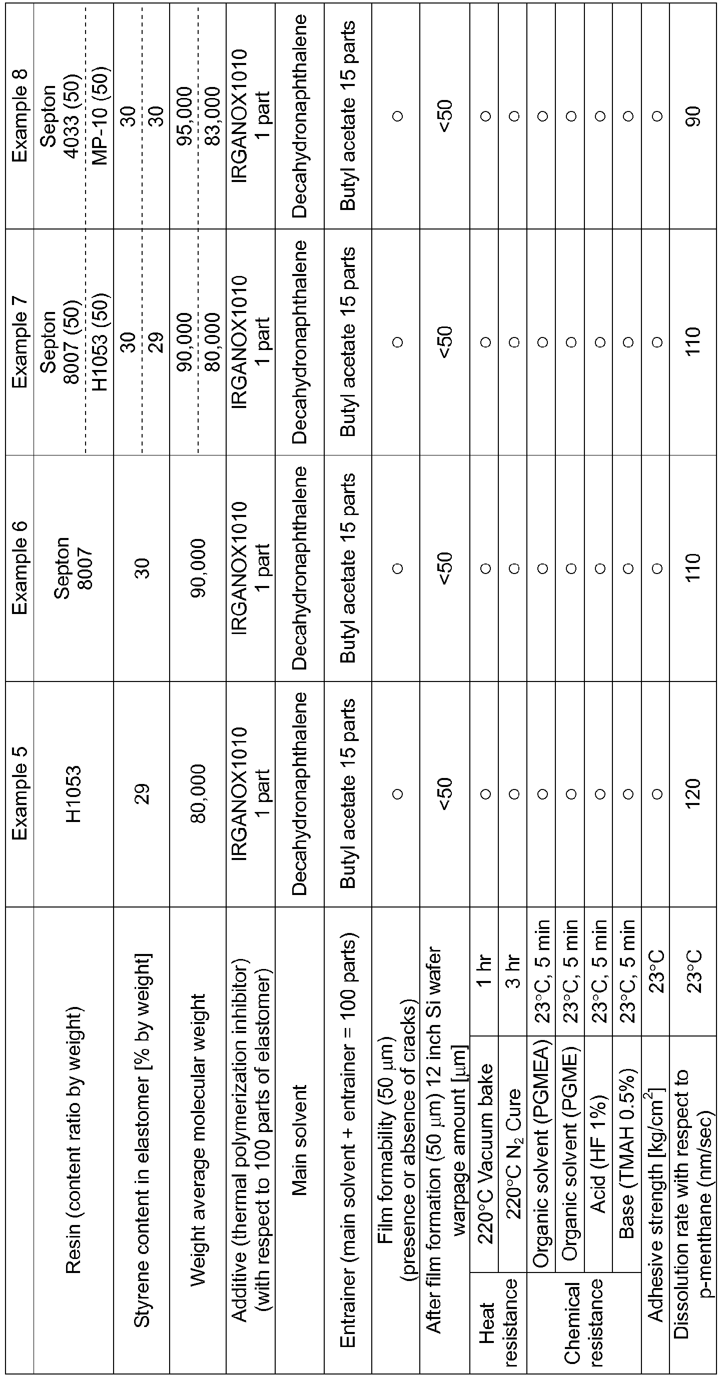

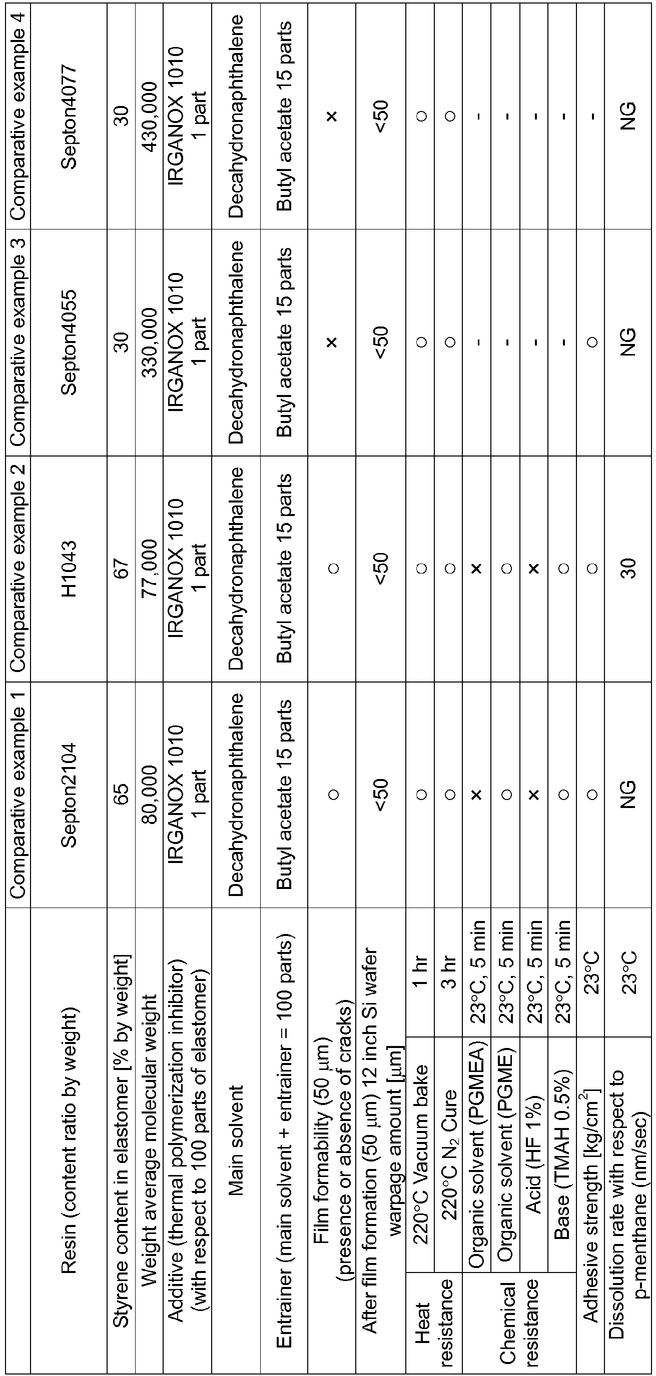

**Table 2**

| | | | Example 9 |
|---|---|---|---|
| Resin (resin component) | | | Septon V9827 |
| Content of styrene-based hard block in elastomer [% by weight] | | | 30 |
| Molecular weight | | | 90,000 |
| Additive (thermal polymerization inhibitor) (with respect to 100 parts of elastomer) | | | IRGANOX1010 1 part |
| Main solvent | | | Decahydranaphthalene |
| Entrainer (main solvent + entrainer = 100 parts) | | | Butyl acetate 15% |
| Film formability (50 µm) (presence or absence of cracks) | | | ○ |
| After film formation (50 µm) 12 inch Si wafer warpage amount [µm] | | | <50 |
| Heat resistance | 220°C Vacuum bake | 1 hr | ○ |
| | 220°C N₂ Cure (3 hr) | 3 hr | ○ |
| Chemical resistance | Organic solvent (PGMEA) | 23°C, 5 min | ○ |
| | Organic solvent (PGME) | 23°C, 5 min | ○ |
| | Acid (HF 1%) | 23°C, 5 min | ○ |
| | Base (TMAH 0.5%) | 23°C, 5 min | ○ |
| Adhesive strength [kg/cm²] | | 23°C | ○ |
| Dissolution rate with respect to p-menthane (nm/sec) | | 23°C | 110 |

As shown in Tables 1 and 2, the solubility with respect to solvents in the examples was more excellent compared to that in the comparative examples.

### Industrial Applicability

The adhesive composition and the adhesive film according to the present invention can be, for example, suitably used in a manufacturing process of a fine semiconductor device.

## Claims

1. A method comprising:
(a) heating, at a temperature equal to or greater than 150 °C, a laminate including a wafer, an adhesive layer, and a support which are laminated in this order, the adhesive layer being formed of an adhesive composition containing an elastomer in which a styrene unit is contained as a constituent unit of a main chain, a content of the styrene unit is 14% by weight to 50% by weight, and a weight average molecular weight is 10,000 to 200,000; and
(b) after step (a), removing the adhesive layer on the wafer by use of a solvent.

2. The method according to Claim 1, wherein the elastomer is a hydrogenated product.

3. The method according to Claim 1 or 2, wherein both terminals of the elastomer are block polymers of styrene.

4. The method according to any one of Claims 1 to 3, wherein the elastomer is a hydrogenated product of a block copolymer of styrene and conjugated diene.

5. The method according to any one of Claims 1 to 4, wherein the wafer is subjected to a thinning process after having been bonded to the support.

6. The method according to any one of Claims 1 to 5, wherein the wafer is exposed under an environment of equal to or higher than 150 °C after having been bonded to the support.

7. The method according to any one of Claims 1 to 6, wherein the laminate is prepared by use of an adhesive film, comprising on a film the adhesive layer including the adhesive composition.

8. The method according to any one of Claims 1 to 7, wherein the laminate further includes a release layer which is changed in quality by absorbing light between the adhesive layer and the support.

9. The method according to any one of Claims 1 to 8, comprising thinning the wafer of the laminate.

10. The method according to Claim 1, wherein the adhesive layer is removed by use of the solvent after separating the support and the wafer by changing the reaction layer in quality.

11. The method according to Claim 1, wherein the wafer and the support are separated by dissolving the adhesive layer by the solvent.

12. The method according to Claim 11, wherein the support has through hole.

## Patentansprüche

1. Verfahren, umfassend:
(a) Erhitzen eines Laminats, das einen Wafer, eine Klebstoffschicht und einen Träger beinhaltet, die in dieser Reihenfolge laminiert sind, bei einer Temperatur größer gleich 150 °C, wobei die Klebstoffschicht von einer Klebstoffzusammensetzung gebildet wird, die ein Elastomer enthält, in dem eine Styroleinheit als eine Bestandteileinheit einer Hauptkette enthalten ist, wobei ein Gehalt der Styroleinheit 14 Gew.-% bis 50 Gew.-% beträgt und ein Molekulargewicht-Gewichtsmittel 10.000 bis 200.000 beträgt; und
(b) nach Schritt (a) Entfernen der Klebstoffschicht auf dem Wafer durch Verwendung eines Lösungsmittels.

2. Verfahren nach Anspruch 1, wobei das Elastomer ein hydriertes Produkt ist.

3. Verfahren nach Anspruch 1 oder 2, wobei beide Termini des Elastomers Blockpolymere von Styrol sind.

4. Verfahren nach einem der Ansprüche 1 bis 3, wobei das Elastomer ein hydriertes Produkt eines Blockcopolymers von Styrol und konjugiertem Dien ist.

5. Verfahren nach einem der Ansprüche 1 bis 4, wobei der Wafer einem Ausdünnungsvorgang unterzogen wird, nachdem er an den Träger gebondet wurde.

6. Verfahren nach einem der Ansprüche 1 bis 5, wobei der Wafer einer Umgebung größer gleich 150 °C ausgesetzt wird, nachdem er an den Träger gebondet wurde.

7. Verfahren nach einem der Ansprüche 1 bis 6, wobei das Laminat durch Verwendung eines Klebstofffilms hergestellt wird, wobei die Klebstoffschicht, die die Klebstoffzusammensetzung beinhaltet, auf einem Film umfasst ist.

8. Verfahren nach einem der Ansprüche 1 bis 7, wobei das Laminat weiterhin eine Trennschicht, deren Qualität durch Absorbieren von Licht verändert wird, zwischen der Klebstoffschicht und dem Träger beinhaltet.

9. Verfahren nach einem der Ansprüche 1 bis 8, das das Ausdünnen des Wafers des Laminats umfasst.

10. Verfahren nach Anspruch 1, wobei die Klebstoffschicht durch Verwendung des Lösungsmittels nach dem Trennen des Trägers und des Wafers durch Verändern der Qualität der Reaktionsschicht entfernt wird.

11. Verfahren nach Anspruch 1, wobei der Wafer und der Träger durch Auflösen der Klebstoffschicht durch das Lösungsmittel getrennt werden.

12. Verfahren nach Anspruch 11, wobei der Träger eine Durchgangsbohrung aufweist.

## Revendications

1. Procédé comprenant les étapes consistant à :
(a) chauffer, à une température égale ou supérieure à 150 °C, un stratifié incluant une tranche, une couche adhésive, et un support qui sont stratifiés dans cet ordre, la couche adhésive étant formée d'une composition adhésive contenant un élastomère dans lequel une unité styrène est contenue comme une unité constitutive d'une chaîne principale, une teneur de l'unité styrène est 14 % en poids à 50 % en poids, et une masse moléculaire moyenne en poids est 10 000 à 200 000 ; et
(b) après l'étape (a), le retrait de la couche adhésive sur la tranche au moyen d'un solvant.

2. Procédé selon la revendication 1, dans lequel l'élastomère est un produit hydrogéné.

3. Procédé selon la revendication 1 ou 2, dans lequel les deux terminaisons de l'élastomère sont des polymères séquencés de styrène.

4. Procédé selon l'une quelconque des revendications 1 à 3, dans lequel l'élastomère est un produit hydrogéné d'un copolymère séquencé de styrène et de diène conjugué.

5. Procédé selon l'une quelconque des revendications 1 à 4, dans lequel la tranche est soumise à un procédé d'amincissement après avoir été liée au support.

6. Procédé selon l'une quelconque des revendications 1 à 5, dans lequel la tranche est exposée sous un environnement égal ou supérieur à 150 °C après avoir été liée au support.

7. Procédé selon l'une quelconque des revendications 1 à 6, dans lequel le stratifié est préparé en utilisant un film adhésif, comprenant sur un film la couche adhésive incluant la composition adhésive.

8. Procédé selon l'une quelconque des revendications 1 à 7, dans lequel le stratifié inclut en outre une couche de séparation qui est changée en qualité en absorbant la lumière entre la couche adhésive et le support.

9. Procédé selon l'une quelconque des revendications 1 à 8, comprenant l'amincissement de la tranche du stratifié.

10. Procédé selon la revendication 1, dans lequel la couche adhésive est retirée au moyen du solvant après avoir séparé le support et la tranche en changeant la couche de réaction en qualité.

11. Procédé selon la revendication 1, dans lequel la tranche et le support sont séparés en dissolvant la couche adhésive par le solvant.

12. Procédé selon la revendication 11, dans lequel le support possède un trou traversant.
